# EUROPÄISCHE PATENTSCHRIFT

(11) **EP 4 279 928 B1**
(45) Veröffentlichungstag und Bekanntmachung des Hinweises auf die Patenterteilung: **11.12.2024**
(21) Anmeldenummer: 23164965.8
(22) Anmeldetag: 29.03.2023
(51) Int. Cl.: G01R 19/165, G08B 21/08, G08B 21/18, G01R 27/22, G01R 19/155, G01R 29/08

(54) **SPANNUNGSWARNVORRICHTUNG UND VERFAHREN ZUM SCHUTZ VOR ELEKTRISCHEM SCHLAG IN EINEM ÜBERFLUTETEN BEREICH**
VOLTAGE WARNING DEVICE AND METHOD FOR PROTECTING AGAINST ELECTRIC SHOCK IN A FLOODED REGION
DISPOSITIF D'AVERTISSEMENT DE TENSION ET PROCÉDÉ DE PROTECTION CONTRE LES CHOCS ÉLECTRIQUES DANS UNE ZONE NOYÉE

(30) Priorität: 13.04.2022 DE 102022109051
(43) Veröffentlichungstag der Anmeldung: 22.11.2023
(73) Patentinhaber: Bender GmbH & Co. KG, 35305 Grünberg (DE)
(72) Erfinder: REITZ, Julian, 35305 Grünberg (DE)
(74) Vertreter: advotec.

(56) Entgegenhaltungen:
- US-A1- 2017 109 994
- US-A1- 2017 353 027
- US-A1- 2018 308 338
- US-A1- 2019 302 154

## Beschreibung

Die Erfindung betrifft eine Spannungswarnvorrichtung und ein Verfahren zum Schutz vor elektrischem Schlag in einem überfluteten Bereich mit elektrischen Einrichtungen.

Bedingt durch Starkregenereignisse sehen sich Rettungskräfte wie die Feuerwehr vermehrt mit Einsatzlagen in überfluteten Bereichen konfrontiert. Oftmals sind Räumlichkeiten von privaten Haushalten oder Industriegebäuden verursacht durch überlastete Kanäle oder über Ufer tretende Flüsse mit Wasser überflutet. Ein direktes Vordringen in die überfluteten Bereiche lässt sich insbesondere bei der Rettung von Menschenleben oft nicht vermeiden. Das hineingeströmte Wasser ist häufig stark verunreinigt, wodurch neben schlechten Sichtverhältnissen unter Wasser auch eine erhöhte elektrische Leitfähigkeit des Wassers besteht.

In Verbindung mit elektrischen Anlagen besteht in den überfluteten Bereichen somit ein hohes Gefahrenpotenzial durch elektrischen Schlag. Es ist oftmals nicht bekannt, welche Anlagenteile unter Spannung stehen, denn je nach Gebäudeart können dort von einer einfachen Steckdose bis hin zu einer Netzeinspeisung elektrische Installationen auf unterschiedlichen Spannungsebenen vorhanden sein. Eine sichere Abschaltung der elektrischen Anlage, z.B. durch das zuständige Energieversorgungsunternehmen, ist nicht immer zeitnah durchführbar. Sind zudem elektrische Energiespeicher oder Wechselrichter von PV-Anlagen installiert, so ist eine Abschaltung oftmals nicht möglich.

Nicht nur das unmittelbare Betreten des überfluteten Bereichs, sondern auch das Bewegen innerhalb des überfluteten Bereichs ist gefährlich, insbesondere dann, wenn sich die Person in dem Wasser unabsichtlich entlang elektrischer Feldlinien mit entsprechenden Potenzialunterschieden (Spannungen) bewegt. Findet hierbei infolge einer Berührung von Körperteilen mit dem Wasser eine Durchströmung des menschlichen Körpers statt, so muss in Verbindung mit der erhöhten Leitfähigkeit des Wassers mit beeinträchtigenden physiologischen Wirkungen gerechnet werden. Diese Auswirkungen äußern sich beispielsweise in Form von starken unwillkürlichen Muskelkontraktionen, Schwierigkeiten beim Atmen oder reversible Störungen der Herzfunktion.

Für den Personenschutz sind aus dem Stand der Technik Spannungsprüfer bekannt, welche die Sicherheit in solchen Einsatzlagen erhöhen sollen.

Diese Spannungsprüfer, wie beispielsweise der Spannungswarner P2 der Firma Martina Zimmermann GmbH (https://zimmermann.expert/unser-p2/) oder das Modell DSP-HW 2 der Firma Rudolph Tietzsch GmbH & Co. KG (https://www.tietzsch.de/produkt/dsp-hw-2-fuer-hochwasser/ bzw. https://en.tietzsch.de/produkt/dsp-hw-2-for-flooded-installations/) basieren auf einer zweipoligen Spannungsmessung mit dem Erdpotenzial als Bezugspotenzial. Dazu verfügen die genannten Geräte über eine Erdungsleitung mit Erdungsklemme oder Erdungsspieß zum Bereitstellen des Erdpotenzials und über einer Messsonde, welche in das Wasser gehalten oder gelegt wird.

Als Nachteil dieser technischen Ausgestaltung wird vor allem die zwingende Notwendigkeit einer sicheren Erdung als Messbezugspotenzial gesehen. Je nach Bodenbeschaffenheit und baulichen Gegebenheiten im Umfeld ist eine Erdung weder praktisch einfach möglich noch elektrisch sicher, beispielsweise bei trockenem Boden oder fehlender Anbindung von Gebäudemetallteilen an einen Fundamenterder. Als Resultat können Auslöseschwellen der Messgeräte verschoben werden, wodurch personengefährdende Spannungen erst bei weit überschrittenen Grenzwerten oder im schlimmsten Fall gar nicht erkannt werden.

Ein weiterer Nachteil wird in der Messmethode an sich gesehen. Da mit der Messsonde nur ein einziger Potenzialmesspunkt eines möglicherweise vorherrschenden elektrischen Strömungsfeldes erfasst wird, ist diese eine Messung wenig repräsentativ für die Potenzialverteilung in dem gesamten überfluteten Bereich. Im ungünstigsten Fall wäre keine Potenzialdifferenz zu dem Erdpotenzial erkennbar, wenn sich die Messsonde (Potenzialmesspunkt) auf einer Äquipotenzialfläche mit Erdpotenzial befände, vergleichbar mit einem symmetrischen Sternpunkt ohne N-Leiter-Anschluss in einem Dreiphasennetz.

Auch erweist es sich als hinderlich, dass die bekannten Spannungsprüfer entweder permanent gehalten, getragen oder ständig an gesicherte Orte umgesetzt werden müssen und die Hände somit nicht dauerhaft für die eigentliche Arbeit frei sind.

Das Dokument US2017/0109994A1 offenbart eine Spannungswarnvorrichtung zum Schutz vor elektrischem Schlag.

Der vorliegenden Erfindung liegt somit die Aufgabe zugrunde, eine Spannungswarnvorrichtung sowie ein Verfahren zum Schutz vor elektrischem Schlag in einem überfluteten Bereich mit elektrischen Einrichtungen vorzuschlagen, welche neben einer zuverlässigen Erkennung der Gefährdung durch elektrische Spannungen eine vereinfachte Handhabung ermöglichen.

Diese Aufgabe wird mit einer Spannungswarnvorrichtung zum Schutz vor elektrischem Schlag in einem überfluteten Bereich mit elektrischen Einrichtungen gemäß Anspruch 1 gelöst.

Dazu weist die Spannungswarnvorrichtung eine Anzahl n von Messsonden auf, die in dem überfluteten Bereich verteilt angeordnet sind und als Potenzialmesspunkte jeweils ein Messpotenzial zum Ermitteln einer elektrischen Potenzialverteilung in dem überfluteten Bereich aufweisen.

Im Gegensatz zu den aus dem Stand der Technik bekannten Ausführungen mit nur einer Messsonde umfasst die hier vorgeschlagene Spannungswarnvorrichtung mehrere Messsonden, die aufgrund ihrer räumlich verteilten Anordnung ein elektrisches Strömungsfeld in dem überfluteten Bereich abbilden können. Das elektrische Strömungsfeld wird dabei durch eine elektrische Potenzialverteilung beschrieben, die sich aus dem von einer Referenzsonde vorgegebenen, von dem Erdpotenzial unabhängigen, relativen Bezugspotenzial und den von den übrigen Messsonden als weitere Potenzialmesspunkte erfassten Messpotenzialen ergibt.

Die Messsonden sind jeweils aus einem schwimmfähigen Körper gebildet, an dessen Außenseite sich über die Hüllfläche des Körpers verteilt mehrere, jeweils ein Elektrodenpotenzial aufweisende Messelektroden befinden. Damit ist eine direkte Berührung mit dem Wasser an der Wasseroberfläche sichergestellt, sodass die elektrischen Potenziale im Nahbereich der jeweiligen Messsonde zuverlässig gemessen werden können.

Die Messsonden umfassen weiter jeweils eine Elektronikeinheit sowie einen Signalgeber.

Die Elektronikeinheiten verarbeiten die gemessenen Elektrodenpotenziale auf digitaler Ebene und können dabei je nach Funktion der Messsonde (Messsonde mit oder ohne Referenzfunktion) unterschiedlich ausgestaltet sein (siehe unten).

Die Signalgeber senden Warnhinweise in der Form aus, dass personengefährdende Spannungspegel und/oder Richtungsinformationen über Spannungsänderungen optisch oder akustisch signalisiert werden.

Die Messsonden sind über Verbindungsleitungsabschnitte miteinander verbunden und bilden somit eine Sondenkette, die auf der Wasseroberfläche schwimmt.

Die Verbindungsleitungsabschnitte stellen sowohl eine elektrische als auch eine mechanische Verbindung zwischen den Messsonden her.

Indem eine der Messsonden, vorzugsweise die erste oder die letzte Messsonde der Sondenkette, als Referenzsonde bestimmt wird, also deren Messpotenzial als relatives Bezugspotenzial zur Erkennung von Messpotenzialdifferenzen gegenüber den übrigen Messsonden definiert wird, entfällt die Notwendigkeit der Anbindung an einen externen, möglicherweise schwer zugänglichen und elektrisch unsicheren Erdungspunkt.

Das Problem unsicherer Erdanbindungen entfällt somit. Zudem wird die Handhabung einer derartigen Spannungswarnvorrichtung während des Einsatzes deutlich vereinfacht.

Mit Vorteil weist die Elektronikeinheit der nicht als Referenzsonde ausgeführten Messsonden einen Analog-Digital-Umsetzer auf zur Umsetzung der an den betreffenden Messelektroden erfassten Elektrodenpotenziale in digitale Signale.

Mit Ausnahme der Referenzsonde ist jede Messsonde mit einem Analog-Digital-Umsetzer ausgestattet, um die erfassten Elektrodenpotenziale in digitaler Form weiterzuleiten und damit Verfahren der digitalen Signalverarbeitung zur Auswertung zugänglich zu machen.

Weiter weist die Elektronikeinheit der Referenzsonde einen Mikrocontroller auf zur zentralen digitalen Signalverarbeitung.

Sämtliche Auswertevorgänge und Steuerungsprozesse erfolgen zentral in dem Mikrocontroller der Referenzsonde.

In weiteren vorteilhaften Ausgestaltungen ist der Mikrocontroller konfiguriert zum Erkennen einer Messpotenzialdifferenz gegenüber dem Bezugspotenzial an den nicht als Referenzsonde ausgeführten Messsonden.

In dem Mikrocontroller erfolgt nach Inbetriebnahme eine kontinuierliche Prüfung der Messpotenziale für die nicht als Referenzsonde ausgeführten Messsonden daraufhin, ob das von der betreffenden Messsonde erfasste Messpotenzial gegenüber dem Bezugspotenzial eine Messpotenzialdifferenz aufweist (Fernbereichsauswertung). Eine Überschreitung eines voreinstellbaren Messpotenzial-Differenzgrenzwertes wird dem Signalgeber der entsprechenden Messsonde über die Verbindungsleitung mitgeteilt und dort optisch und/oder akustisch signalisiert.

Weiter ist der Mikrocontroller konfiguriert zum Berechnen des Messpotenzials für die nicht als Referenzsonde ausgeführten Messsonden aus den an den Messelektroden der jeweiligen Messsonde erfassten Elektrodenpotenzialen.

Zum Berechnen des Messpotenzials einer jeden Messsonde - die Referenzsonde ist ausgenommen - wird aus den an Messelektroden der jeweiligen Messsonde erfassten Elektrodenpotenzialen ein für diese Messsonde repräsentativer Messwert, beispielsweise durch Mittelwertbildung, als Messpotenzial bestimmt (Nahbereichsauswertung). Die so an den Orten der Messsonden (Potenzialmesspunkte) ermittelten Messpotenziale ergeben die Potenzialverteilung, aus der weitere Berechnungen, wie die Bestimmung eines elektrischen Feldstärkevektors (Gradientenbildung), abgeleitet werden können.

Weiter ist der Mikrocontroller konfiguriert, mittels Gradientenbildung aus der Potenzialverteilung die Richtung der größten Spannungsänderung zu berechnen.

Aus der Potenzialverteilung - repräsentiert durch die einzelnen Messpotenziale der Messsonden - wird mittels Gradientenbildung die Richtung der größten Spannungsänderung berechnet. Aus der räumlichen Änderung des elektrischen Potenzials, also des Messpotenzials am Ort einer bestimmten Messsonde, können somit die elektrische Feldstärke und damit die Richtung der größten Spannungsänderung bestimmt und mittels der Signalgeber signalisiert werden. Auf diese Weise kann die Gefahr durch elektrischen Strom nicht nur erkannt, sondern auch geortet werden.

Weiter ist der Mikrocontroller konfiguriert zur Erzeugung von Steuersignalen für die Signalgeber, um eine Überschreitung eines voreinstellbaren Messpotenzial-Differenzgrenzwertes zu signalisieren.

Neben der digitalen Signalverarbeitung im Rahmen der Auswertung der erfassten Elektrodenpotenziale erzeugt der Mikrocontroller Steuersignale, mit denen die Signalgeber der Messsonden veranlasst werden, die Überschreitung eines voreinstellbaren Messpotenzial-Differenzgrenzwertes zu signalisieren. Der voreinstellbare Messpotenzial-Differenzgrenzwert kann dabei an Gefahrenstufen angepasst werden.

Weiterhin kann die Referenzsonde über eine Erdleitung mit einem definierten Erdpotenzial als Bezugspotenzial verbunden sein.

Zwar wird die Funktion des Bezugspotenzials durch das von der Referenzsonde festgelegte, von dem Erdpotenzial unabhängige, relative Bezugspotenzial erfüllt, dennoch besteht die Möglichkeit, dieses Bezugspotenzial über eine Erdleitung an das Erdpotenzial anzubinden.

Bevorzugt weist die Referenzsonde einen Energiespeicher zur Energieversorgung der Messsonden auf.

Die Energieversorgung der Messsonden erfolgt über einen als wiederaufladbares Speicherelement (Akku) oder als Batterie ausgeführten Energiespeicher, der bevorzugt in der Referenzsonde angeordnet und über eine Versorgungsleitung mit den übrigen Messsonden verbunden ist.

Vorzugsweise umfasst eine aus den Verbindungsleitungsabschnitten bestehende Verbindungsleitung eine Kommunikationsleitung, einen Masseleiter und eine Versorgungsleitung.

Die Verbindungsleitung weist einen Masseleiter auf, der optional über die Erdleitung mit dem Erdpotenzial verbunden werden kann.

Bevorzugt ist die Kommunikationsleitung zur Datenübertragung der digitalen Elektrodenpotenziale und der Steuersignale konfiguriert.

Die Übertragung der digitalen Elektrodenpotenziale und der Steuersignale erfolgt in digitaler Form beispielsweise über eine als RS485, SPI-Bus oder CAN-Bus ausgeführte Kommunikationsleitung.

Vorzugsweise sind die schwimmfähigen Körper kugelförmig ausgebildet und bestehen aus lichtdurchlässigem Kunststoff, wobei der Signalgeber ein Schallwandler und/oder eine durch den lichtdurchlässigen Kunststoff strahlende Leuchteinrichtung mit unterschiedlicher Farbdarstellung und mehreren Leuchtmodi zur Signalisierung unterschiedlicher Gefahrenstufen ist.

Das transparente Kunststoffmaterial ermöglicht die Ausstattung der schwimmfähigen Körper mit innenliegenden Leuchteinrichtungen, die in Abhängigkeit der Überschreitung eines voreinstellbaren Messpotenzial-Differenzgrenzwertes, also entsprechend der unterschiedlichen Gefahrenstufen, in unterschiedlichen Farben und mit verschiedenen Leuchtmodi leuchten - beispielsweise in grüner Dauerbeleuchtung bei gefahrlosem Spannungspegel in dem überfluteten Bereich, mit rotem Blinklicht bei Gefahr und als Lauflicht zur Signalisierung der Richtung der größten Spannungsänderung (Gradient).

Die zuvor beschriebene erfindungsgemäße Spannungswarnvorrichtung setzt die in dem unabhängigen Verfahrensanspruch 14 beschriebenen Verfahrensschritte um. Insoweit treffen die vorgenannten technischen Wirkungen und daraus entstehenden verfahrenstechnischen Vorteile auch auf die Verfahrensmerkmale zu.

Weitere vorteilhafte Ausgestaltungsmerkmale ergeben sich aus der nachfolgenden Beschreibung und den Zeichnungen, die eine bevorzugte Ausführungsform der Erfindung an Hand von Beispielen erläutern. Es zeigen:
- **Fig. 1:**: eine erfindungsgemäße Spannungswarnvorrichtung,
- **Fig. 2:**: eine erfindungsgemäße Spannungswarnvorrichtung mit Potenzialverteilung in einem überfluteten Bereich,
- **Fig. 3:**: ein funktionales Blockdiagramm der erfindungsgemäßen Spannungswarnvorrichtung,
- **Fig. 4:**: Simulation der Potenzialverteilung mit einer Steckdose unter Wasser,
- **Fig. 5:**: Simulation der Potenzialverteilung mit zwei Steckdosen unter Wasser und
- **Fig. 6:**: Simulation der Potenzialverteilung mit einer Steckdose mit nur einem aktiven Leiter unter Wasser.

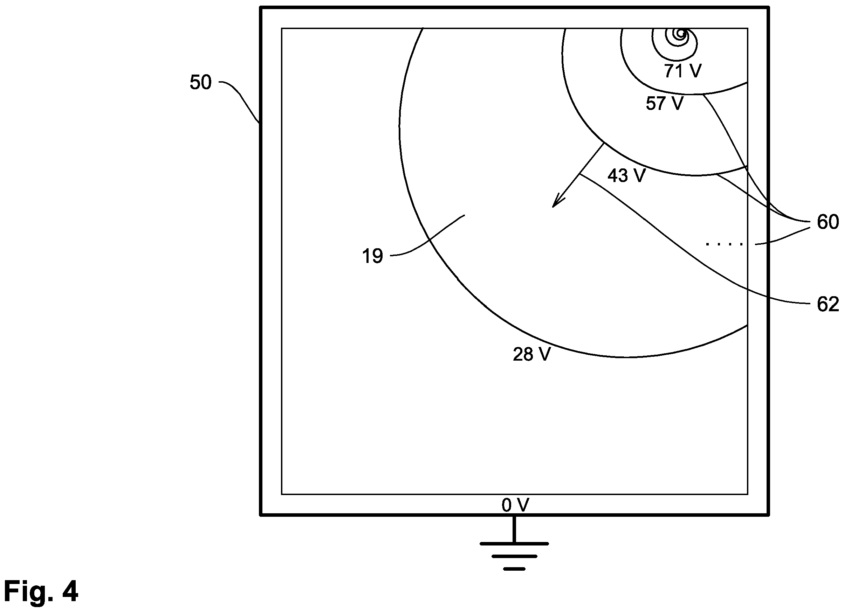

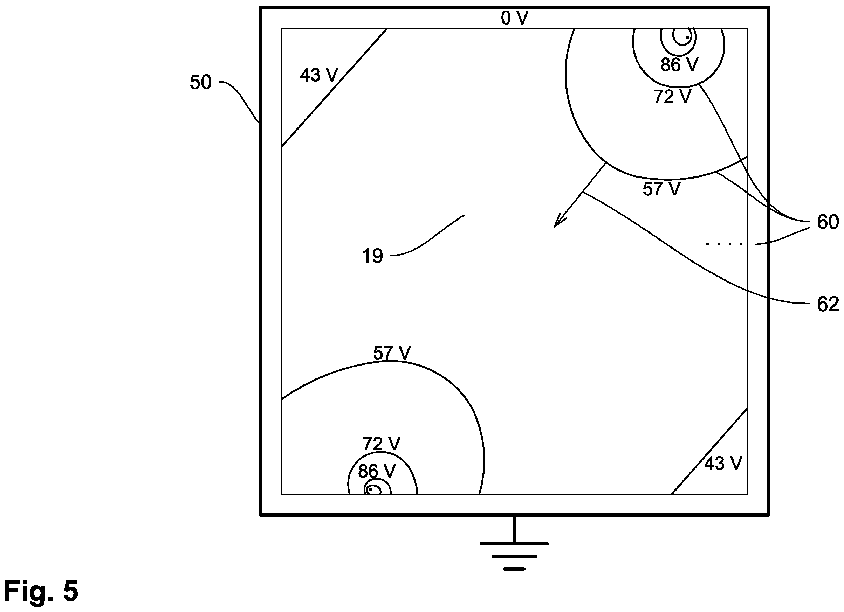

Um die der vorliegenden Erfindung zugrundeliegende Aufgabenstellung zu verdeutlichen, werden in den **Fig. 4 bis 6** zunächst Simulationsergebnisse von Verteilungen des elektrischen Potenzials 19 in einem mit verunreinigtem Wasser überfluteten Bereich 50 gezeigt. Zugrunde gelegt ist ein mit verunreinigtem Wasser überfluteter Raum der Grundfläche 5m*5m, in dem als Spannungsquelle(n) eine (**Fig. 4**) oder zwei (**Fig. 5**) 230V-Steckdosen sowie eine 230V-Steckdose mit nur einem aktiven Leiter (**Fig. 5**) unter Wasser nachgebildet wird/werden.

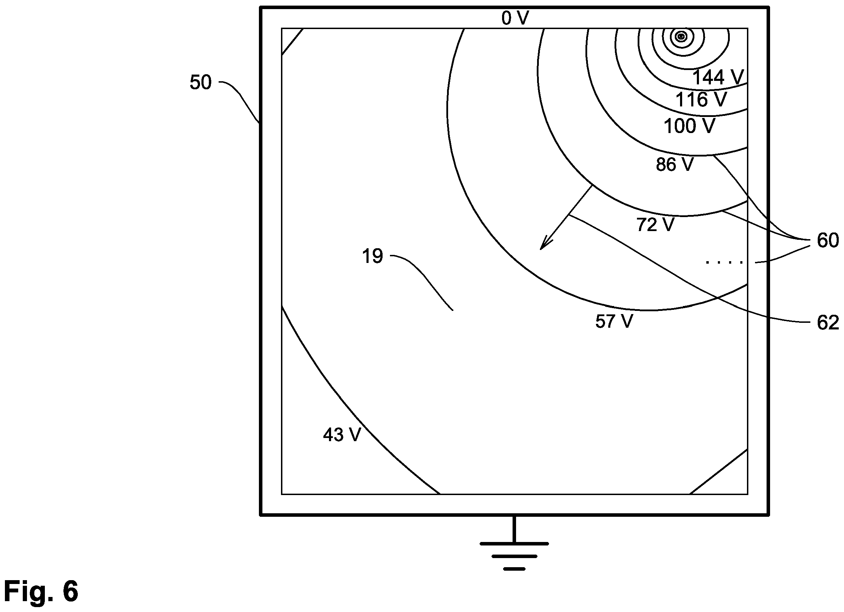

Insbesondere in **Fig. 4** **und** **Fig. 6** mit nur einer - als Punktquelle betrachteten - Spannungsquelle ist ein nahezu kreisförmiger Verlauf der Potenzialverteilung 19 mit Äquipotenziallinien 60 und senkrecht auf den Äquipotenziallinien 60 stehendem Gradient 62 der elektrischen Feldstärke erkennbar.

Personengefährdende Spannungspegel werden unter diesen Annahmen über weitläufige Bereiche erreicht. Eine zuverlässige Erkennung der Potenzialdifferenzen (Spannungen) erscheint daher unabdingbar.

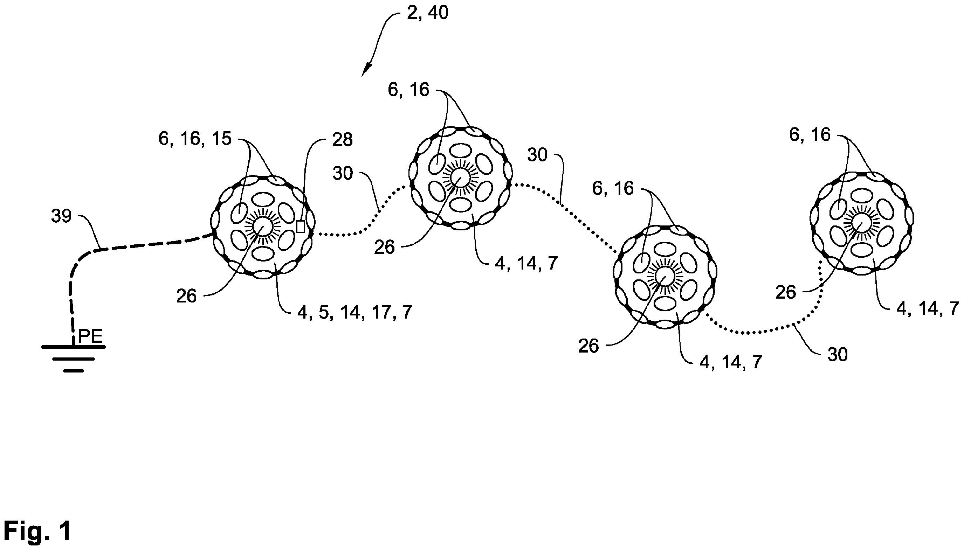

**Fig. 1** zeigt eine erfindungsgemäße Spannungswarnvorrichtung 2 mit n=4 Messsonden 4, die über Verbindungsleitungsabschnitte 30 zu einer Sondenkette 40 miteinander verbunden sind. Die Abstände zwischen den einzelnen Messsonden 4 sollten zwischen 0,5m bis 2m betragen. Die Anzahl der Messsonden 4 und die Abstände können aber in Abhängigkeit des Einsatzortes variieren.

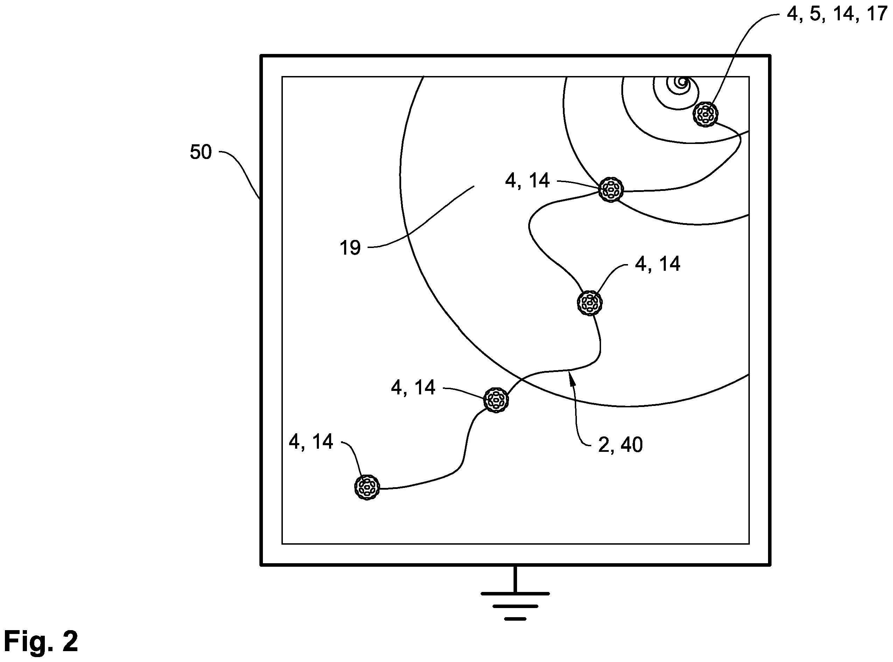

Die Messsonden 4 sind als schwimmfähige Körper 7 ausgebildet, an deren Außenflächen verteilt jeweils Messelektroden 6 angebracht sind, die einen unmittelbaren elektrischen Kontakt mit dem Wasser in dem überfluteten Bereich 50 (Fig. 2) sicherstellen. Die Messelektroden 6 sollten aus rostfreien Metallen, wie Edelstahl oder Messing gefertigt sein.

Die Messsonden 4 sind vorzugsweise kugelförmig ausgebildet und bestehen aus lichtdurchlässigem Kunststoff, sodass ein im Inneren der Messsonde 4 befindlicher, als Leuchteinrichtung ausgebildeter Signalgeber 26 von außen sichtbare Warnhinweise aussenden kann.

Jede Messelektrode 6 einer jeden Messsonde 4 weist ein bestimmtes Elektrodenpotenzial 16 auf, wobei eine der Messsonden 6 als Referenzsonde 5 wirkt, deren Messelektroden 6 als Referenzelektroden 15 alle ein gleiches Elektrodenpotenzial 16 besitzen, welches einem relativem Bezugspotenzial 17 als Messpotenzial 14 der Referenzsonde 5 ohne Anbindung an ein Erdpotenzial PE entspricht.

Obgleich die Bereitstellung eines von dem Erdpotenzial PE unabhängigen, relativen Bezugspotenzials 17 einen wesentlichen Aspekt der Erfindung darstellt, besteht die Möglichkeit, mittels einer Erdleitung 39 das relative Bezugspotenzial 17 auf ein absolutes Bezugspotenzial mit Erdpotenzial PE zu legen.

Die Messsonden 4 ebenso wie die aus den Verbindungsleitungsabschnitten 30 bestehende Verbindungsleitung sollten die Schutzart IP68 (Staubund Wasserdicht) aufweisen.

Die Verbindungsleitungsabschnitte können durch Einlagen verstärkt sein und wirken gleichzeitig als flexible mechanische Verbindung zwischen den Messsonden.

**Fig. 2** zeigt die Spannungswarnvorrichtung 2 in einem überfluteten Bereich 50 mit simulierter Spannungsquelle unter Wasser und der resultierenden Potenzialverteilung 19. An den Orten der Messsonden 4 wird ein Messpotenzial 14 entsprechend der sich einstellenden Potenzialverteilung 19 in dem elektrischen Strömungsfeld ermittelt bzw. an dem Ort der Referenzsonde 5 durch das relative Bezugspotenzial 17 vorgegeben.

Die Sondenkette 40 wird zunächst, beispielsweise an einer Leine gesichert, ins Wasser geworfen. Meldet die Sondenkette 40 keinen Warnhinweis (Alarm), so kann der überflutete Bereich 50 an dieser Stelle betreten werden. Bewegt man sich weiter im überfluteten Bereich 50 vor, so wird die Sondenkette 40 von der vorgehenden Person ständig um sie herum geschwenkt. Werden dabei personengefährdende Spannungspegel erkannt, erfolgt ein Alarm. Ein weiteres Vorgehen sollte dann unterlassen werden.

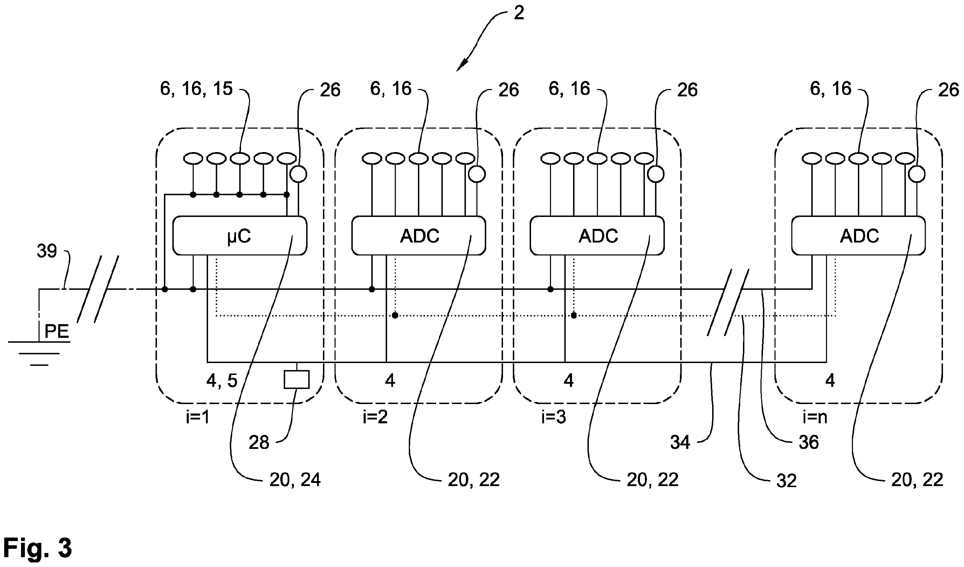

In **Fig. 3** ist ein funktionales Blockdiagramm der erfindungsgemäßen Spannungswarnvorrichtung 2 mit n Messsonden 4 dargestellt.

Die Messsonde 4 an der Stelle i=1 bildet die Referenzsonde 5 und stellt mittels der als Referenzelektroden 15 wirkenden Messelektroden 6 über einen Masseleiter 36 das Elektrodenpotenzial 16 an der Referenzsonde 5 bereit, welches dem relativen Bezugspotenzial 17 (Figs. 1, 2) entspricht.

Die nachfolgenden Messsonden 4 an den Stellen i=2 bis n erfassen über ihre jeweiligen Messelektroden 6 das dort vorherrschende Elektrodenpotenzial 16 und leiten dieses nach der Analog-Digital-Umsetzung 22 (ADU) über die Kommunikationsleitung 32 an den Mikrocontroller 24 der Referenzsonde 5 weiter.

Der Mikrocontroller 24 ermittelt das jeweilige Messpotenzial 14 (Figs. 1, 2) an den Stellen i=2 bis n, indem im Nahbereich (um die Stellen i=2 bis n) jeweils aus den dort erfassten Elektrodenpotenzialen 16 ein repräsentativer Wert für das Messpotenzial 14 als Potenzialmesspunkt, beispielsweise durch Mittelwertbildung in Verbindung mit digitalen Filteroperationen, berechnet wird (Nahbereichsauswertung). Die so ermittelten Messpotenziale 14 bilden die Potenzialverteilung 19 räumlich ab, sodass Messpotenzialdifferenzen sicher erkannt werden (Fernbereichsauswertung).

Über eine Versorgungsleitung 34 werden die Messsonden 4 von dem Energiespeicher 28 der Referenzsonde 5 mit Energie versorgt.

Die Kombination aus Nahbereichsauswertung und Fernbereichsauswertung kann ausgehend von der Abbildung der Potenzialverteilung 19 zu einer Berechnung des Gradienten 62 der elektrischen Feldstärke (Figs. 4 bis 6) genutzt werden. Hierdurch können personengefährdende Bewegungsrichtungen (entlang des Gradienten 62) und weniger gefährdende Bewegungsrichtungen (entlang der Äquipotenziallinien 60) der handelnden Person im Vorfeld des Einsatzes identifiziert werden.

## Patentansprüche

1. Spannungswarnvorrichtung (2) zum Schutz vor elektrischem Schlag in einem überfluteten Bereich (50) mit elektrischen Einrichtungen (52),
mit einer in dem überfluteten Bereich (50) verteilt angeordneten Anzahl n von Messsonden (4),
die als Potenzialmesspunkte jeweils ein Messpotenzial (14) zum Ermitteln einer elektrischen Potenzialverteilung (19) in dem überfluteten Bereich (50) aufweisen und
die jeweils aus einem schwimmfähigen Körper (7) mit an dessen Außenseite angeordneten, ein Elektrodenpotenzial (16) aufweisende Messelektroden (6), aus einer Elektronikeinheit (20, 22, 24) sowie aus einem Signalgeber (26) bestehen,
**dadurch gekennzeichnet, dass** die Messsonden (4) über Verbindungsleitungsabschnitte (30) zu einer schwimmfähigen Sondenkette (40) miteinander verbunden sind,
und dass eine der Messsonden (4) als Referenzsonde (5) zur Festlegung eines relativen Bezugspotenzials (17) als Messpotenzial (14) ohne Anbindung an ein Erdpotenzial (PE) konfiguriert ist.

2. Spannungswarnvorrichtung nach Anspruch 1,
**dadurch gekennzeichnet,**
**dass** die Elektronikeinheit (20) der nicht als Referenzsonde (5) ausgeführten Messsonden (4) einen Analog-Digital-Umsetzer (22) aufweist zur Umsetzung der an den betreffenden Messelektroden (6) erfassten Elektrodenpotenziale (16) in digitale Signale.

3. Spannungswarnvorrichtung nach Anspruch 1 oder 2,
**dadurch gekennzeichnet,**
**dass** die Elektronikeinheit (20) der Referenzsonde (5) einen Mikrocontroller (24) aufweist zur zentralen digitalen Signalverarbeitung.

4. Spannungswarnvorrichtung nach Anspruch 3,
**dadurch gekennzeichnet,**
**dass** der Mikrocontroller (24) konfiguriert ist zum Erkennen einer Messpotenzialdifferenz gegenüber dem Bezugspotenzial (17) an den nicht als Referenzsonde (5) ausgeführten Messsonden (4).

5. Spannungswarnvorrichtung nach Anspruch 3 oder 4,
**dadurch gekennzeichnet,**
**dass** der Mikrocontroller (24) konfiguriert ist zum Berechnen des Messpotenzials (14) für die nicht als Referenzsonde (5) ausgeführten Messsonden (4) aus den an den Messelektroden (6) der jeweiligen Messsonde (4) erfassten Elektrodenpotenzialen (16).

6. Spannungswarnvorrichtung nach einem der Ansprüche 3 bis 5,
**dadurch gekennzeichnet,**
**dass** der Mikrocontroller (24) konfiguriert ist, mittels Gradientenbildung aus der Potenzialverteilung (19) die Richtung der größten Spannungsänderung zu berechnen.

7. Spannungswarnvorrichtung nach einem der Ansprüche 3 bis 6,
**dadurch gekennzeichnet,**
**dass** der Mikrocontroller (24) konfiguriert ist zur Erzeugung von Steuersignalen (18) für die Signalgeber (26), um eine Überschreitung eines voreinstellbaren Messpotenzial-Differenzgrenzwertes zu signali sieren.

8. Spannungswarnvorrichtung nach einem der Ansprüche 1 bis 7,
**dadurch gekennzeichnet,**
**dass** die Referenzsonde (5) über eine Erdleitung (39) mit einem definierten Erdpotenzial (PE) als Bezugspotenzial (17) verbunden ist.

9. Spannungswarnvorrichtung nach einem der Ansprüche 1 bis 7,
**dadurch gekennzeichnet,**
**dass** die Referenzsonde (5) einen Energiespeicher (28) zur Energieversorgung der Messsonden (4) aufweist.

10. Spannungswarnvorrichtung nach einem der Ansprüche 1 bis 9,
**dadurch gekennzeichnet,**
**dass** eine aus den Verbindungsleitungsabschnitten (30) bestehende Verbindungsleitung eine Kommunikationsleitung (32), einen Masseleiter (36) und eine Versorgungsleitung (34) aufweist.

11. Spannungswarnvorrichtung nach Anspruch 10,
**dadurch gekennzeichnet,**
**dass** die Kommunikationsleitung (32) zur Datenübertragung der digitalen Elektrodenpotenziale und der Steuersignale (18) konfiguriert ist.

12. Spannungswarnvorrichtung nach einem der Ansprüche 1 bis 11,
**dadurch gekennzeichnet,**
**dass** die schwimmfähigen Körper (7) kugelförmig ausgebildet sind und aus lichtdurchlässigem Kunststoff bestehen.

13. Spannungswarnvorrichtung nach einem der Ansprüche 1 bis 12,
**dadurch gekennzeichnet,**
**dass** der Signalgeber (26) ein Schallwandler und/oder eine Leuchteinrichtung mit unterschiedlicher Farbdarstellung und mehreren Leuchtmodi zur Signalisierung unterschiedlicher Gefahrenstufen ist.

14. Verfahren zum Schutz vor elektrischem Schlag in einem überfluteten Bereich (50) mit elektrischen Einrichtungen (52), umfassend die Verfahrensschritte:
Ermitteln einer elektrischen Potenzialverteilung (19) in dem überfluteten Bereich (50) mittels einer in dem überfluteten Bereich (50) verteilt angeordneten Anzahl n von Messsonden (4), die als Potenzialmesspunkte jeweils ein Messpotenzial (14) aufweisen und die jeweils aus einem schwimmfähigen Körper (7) mit an dessen Außenseite angeordneten, ein Elektrodenpotenzial (16) aufweisende Messelektroden (6), aus einer Elektronikeinheit (20) sowie aus einem Signalgeber (26) und einer Stromversorgung (28) bestehen,
**dadurch gekennzeichnet, dass** die Messsonden (4) über Verbindungsleitungsabschnitte (30) zu einer schwimmfähigen Sondenkette (40) miteinander verbunden sind,
und dass das Messpotenzial (14) einer Referenzsonde (5) ohne Anbindung an ein Erdpotenzial (PE) als relatives Bezugspotenzial (17) festgelegt wird.

15. Verfahren nach Anspruch 14,
**dadurch gekennzeichnet,**
**dass** an den nicht als Referenzsonden (5) ausgeführten Messsonden (4) die von den betreffenden Messelektroden (6) erfassten Elektrodenpotenziale (16) mittels eines Analog-Digital-Umsetzers (22) in der Elektronikeinheit (20) der nicht als Referenzsonden (5) ausgeführten Messsonden (4) in digitale Signale umgesetzt werden.

16. Verfahren nach Anspruch 14 oder 15,
**dadurch gekennzeichnet,**
**dass** digitale Signalverarbeitungsschritte durch einen Mikrocontroller (24) in der Elektronikeinheit (20) der Referenzsonde (5) zentral ausgeführt werden.

17. Verfahren nach Anspruch 16,
**dadurch gekennzeichnet,**
**dass** an den nicht als Referenzsonde (5) ausgeführten Messsonden (4) gegenüber dem Bezugspotenzial (17) auftretende Messpotenzialdifferenzen von dem Mikrocontroller (24) erkannt werden.

18. Verfahren nach Anspruch 16 oder 17,
**dadurch gekennzeichnet,**
**dass** das Messpotenzial (14) für jede nicht als Referenzsonde (5) ausgeführte Messsonde (4) aus den an den Messelektroden (6) der betreffenden Messsonde (4) erfassten Elektrodenpotenzialen (16) in dem Mikrocontroller (24) berechnet wird.

19. Verfahren nach einem der Ansprüche 16 bis 18,
**dadurch gekennzeichnet,**
**dass** mittels Gradientenbildung aus der Potenzialverteilung (19) die Richtung der größten Spannungsänderung in dem Mikrocontroller (24) berechnet wird.

20. Verfahren nach einem der Ansprüche 16 bis 19,
**dadurch gekennzeichnet,**
**dass** von dem Mikrocontroller (24) Steuersignale (18) für die Signalgeber (26) erzeugt werden, um eine Überschreitung eines voreinstellbaren Messpotenzial-Differenzgrenzwertes zu signalisieren.

21. Verfahren nach einem der Ansprüche 14 bis 20,
**dadurch gekennzeichnet,**
**dass** die Referenzsonde (5) über eine Erdleitung (39) mit einem definierten Erdpotenzial (PE) als Bezugspotenzial (17) verbunden wird.

22. Verfahren nach einem der Ansprüche 14 bis 21,
**dadurch gekennzeichnet,**
**dass** die Energieversorgung der Messsonden über einen Energiespeicher (28) der Referenzsonde (5) erfolgt.

23. Verfahren nach einem der Ansprüche 14 bis 22,
**dadurch gekennzeichnet,**
**dass** eine aus den Verbindungsleitungsabschnitten (30) bestehende Verbindungsleitung eine Kommunikationsleitung (32), einen Masseleiter (36) und eine Versorgungsleitung (34) aufweist, wobei über die Kommunikationsleitung (32) die digitalen Elektrodenpotenziale und die Steuersignale (18), übertragen werden.

24. Verfahren nach einem der Ansprüche 14 bis 23,
**dadurch gekennzeichnet,**
**dass** die schwimmfähigen Körper (7) kugelförmig ausgebildet sind und aus lichtdurchlässigem Kunststoff bestehen,
wobei unterschiedliche Gefahrenstufen mittels des als Schallwandler und/oder als Leuchteinrichtung mit unterschiedlicher Farbdarstellung und mehreren Leuchtmodi ausgeführten Signalgebers (26) signalisiert werden.

## Claims

1. A shock alert warning device (2) for protection from electric shock in a flooded area (50) having electric installations (52),
having a number n of measuring probes (4) which are distributed in the flooded area (50) and
which each have a measuring potential (14) as a potential measuring point for detecting an electric potential distribution (19) in the flooded area (50) and
which each consist of a buoyant body (7) having measuring electrodes (6) disposed on its outer side and having an electrode potential (16), of an electronics unit (20, 22, 24) and of a signal generator (26),
**characterized in that**
the measuring probes (4) are connected to each other via connection lead sections (30) to form a buoyant probe chain (40), and **in that** one of the measuring probes (4) is configured as a reference probe (5) for establishing a relative reference potential (17) as a measuring potential (14) without a connection to a ground potential (PE).

2. The shock alert warning device according to claim 1,
**characterized in that**
the electronics unit (20) of the measuring probes (4) not configured as a reference probe (5) has an analog-to-digital converter (22) for converting the electrode potentials (16) registered at the corresponding measuring electrodes (6) to digital signals.

3. The shock alert warning device according to claim 1 or 2,
**characterized in that**
the electronics unit (20) of the reference probe (5) has a microcontroller (24) for central digital signal processing.

4. The shock alert warning device according to claim 3,
**characterized in that**
the microcontroller (24) is configured for identifying a measuring potential difference with respect to the reference potential (17) at the measuring probes (4) not configured as the reference probe (5).

5. The shock alert warning device according to claim 3 or 4,
**characterized in that**
the microcontroller (24) is configured for calculating the measuring potential (14) for the measuring probes (4) not configured as the reference probe (5) from the electrode potentials (16) registered at the measuring electrodes (6) of the corresponding measuring probes (4).

6. The shock alert warning device according to any one of the claims 3 to 5,
**characterized in that**
the microcontroller (24) is configured to calculate the direction of the largest voltage change by means of forming gradients from the potential distribution (19).

7. The shock alert warning device according to any one of the claims 3 to 6,
**characterized in that**
the microcontroller (24) is configured for generating control signals (18) for the signal generator (26) in order to signal when a preset measuring-potential difference threshold is exceeded.

8. The shock alert warning device according to any one of the claims 1 to 7,
**characterized in that**
the reference probe (5) is connected to a defined ground potential (PE) as a reference potential (17) via a ground lead (39).

9. The shock alert warning device according to any one of the claims 1 to 7,
**characterized in that**
the reference probe (5) has an energy storage (28) for supplying power to the measuring probes (4).

10. The shock alert warning device according to any one of the claims 1 to 9,
**characterized in that**
a connection lead consisting of connection lead sections (30) has a communication lead (32), a ground conductor (36) and a supply lead (34).

11. The shock alert warning device according to claim 10,
**characterized in that**
the communication lead (32) is configured for transmitting data of the digital electrode potentials and the control signals (18).

12. The shock alert warning device according to any one of the claims 1 to 11,
**characterized in that**
the buoyant bodies (7) are spheroid and consist of transparent plastic.

13. The shock alert warning device according to any one of the claims 1 to 12,
**characterized in that**
the signal generator (26) is a sound converter and/or an illumination apparatus having different color depictions and several light modes for signaling different danger levels.

14. A method for protection from electric shock in a flooded area (50) having electric installations (52), the method comprising the following steps:
detecting an electric potential distribution (19) in the flooded area (50) by means of a number n of measuring probes (4) which are distributed in the flooded area (50) and each have a measuring potential (14) as a potential measuring point and each consist of a buoyant body (7) having measuring electrodes (6) disposed on its outer side and having electrode potentials (16), of an electronics unit (20) and of a signal generator (26) and of a power supply (28),
**characterized in that**
the measuring probes (4) are connected to each other via connection lead sections (30) to form a buoyant probe chain (40) and **in that** the measuring potential (14) of a reference probe (5) is established as a relative reference potential (17) without being connected to a ground potential (PE).

15. The method according to claim 14,
**characterized in that**
at the measuring probes (4) not configured as reference probes (5), the electrode potentials (16) registered by the corresponding measuring probes (6) are converted to digital signals in the electronics unit (20) of the measuring probes (4) not configured as a reference probe (5) by means of an analog-to-digital converter (22).

16. The method according to claim 14 or 15,
**characterized in that**
digital signal processing steps are implemented centrally in the electronics unit (20) of the reference probe (5) via a microcontroller (24).

17. The method according to claim 16,
**characterized in that**
at the measuring probes (4) not configured as a reference probe (5), measuring potential differences occurring with respect to the reference potential (17) are identified by the microcontroller (24).

18. The method according to claim 16 or 17,
**characterized in that**
the measuring potential (14) for each measuring probe (4) not configured as a reference probe (5) is calculated in the microcontroller from the electrode potentials (16) registered at the measuring electrodes (6) of the corresponding measuring probe (4).

19. The method according to any one of the clams 16 to 18,
**characterized in that**
the direction of the largest voltage change is calculated in the microcontroller (24) from the potential distribution (19) by means of gradient formation.

20. The method according to any one of the claims 16 to 19,
**characterized in that**
control signals (18) are generated by the microcontroller (24) for the signal generator (24) in order to signal when a preset measuring-potential difference threshold is exceeded.

21. The method according to any one of the claims 14 to 20, **characterized in that**
the reference probe (5) is connected to a defined ground potential (PE) as a reference potential (17) via a ground lead (39).

22. The method according to any one of the claims 14 to 21,
**characterized in that**
the measuring probes are supplied with power via an energy storage (28) of the reference probe (5).

23. The method according to any one of the claims 14 to 22,
**characterized in that**
a connection lead consisting of the connection lead sections (30) has a communication lead (32), a ground conductor (36) and a supply lead (34), the digital electrode potentials and the control signals (18) being transmitted via the communication lead (32).

24. The method according to any one of the claims 14 to 23,
**characterized in that**
the buoyant bodies (7) are spheroid and consist of transparent plastic, different danger levels being signaled by means of the signal generator (26) configured as a sound converter and/or an illumination apparatus having different color depictions and several light modes.

## Revendications

1. Dispositif (2) d'avertissement de choc électrique pour la protection contre le choc électrique dans une zone engloutie (50) ayant des installations électriques (52),
ayant un nombre n de probes de mesure (4) qui sont distribuées dans la zone engloutie (50) et
qui ont chacune un potentiel de mesure (14) comme points de mesure pour le potentiel pour la détection d'une distribution de potentiel électrique (19) dans la zone engloutie (50) et
qui consistent chacune en un corps flottable (7) ayant des électrodes de mesure (6) disposées sur sa face externe et ayant un potentiel d'électrode (16), en une unité d'électronique (20, 22, 24) et en un générateur de signal (26),
**caractérisé en ce que**
les probes de mesure (4) sont reliées l'une à l'autre par l'intermédiaire des parties (30) de ligne de connexion afin de former une chaîne de probes (40) flottable, et **en ce qu'**une des probes de mesure (4) est configurée comme probe de référence (5) pour établir un équipotentiel (17) relatif comme potentiel de mesure (14) sans connexion à un potentiel de terre (PE).

2. Dispositif d'avertissement de choc électrique selon la revendication 1,
**caractérisé en ce que**
l'unité d'électronique (20) des probes de mesure (4) qui ne sont pas configurée comme probe de référence (5) a un convertisseur analogique-numérique (22) pour la conversion de potentiels d'électrodes (16) enregistrés aux électrodes de mesure (6) correspondant aux signaux numériques.

3. Dispositif d'avertissement de choc électrique selon la revendication 1 ou la revendication 2,
**caractérisé en ce que**
l'unité d'électronique (20) de la probe de référence (5) a un microcontrôleur (24) pour le traitement central numérique des signaux.

4. Dispositif d'avertissement de choc électrique selon la revendication 3,
**caractérisé en ce que**
le microcontrôleur (24) est configuré pour identifier une différence du potentiel de mesure par rapport à l'équipotentiel (17) aux probes de mesure (4) qui ne sont pas configurées comme probe de référence (5).

5. Dispositif d'avertissement de choc électrique selon la revendication 3 ou la revendication 4,
**caractérisé en ce que**
le microcontrôleur (24) est configuré pour calculer le potentiel de mesure (14) pour les probes de mesure (4) qui ne sont pas configurées comme probe de référence (5) à partir des potentiels d'électrode (16) enregistrés aux électrodes de mesure (6) de probes de mesure (4) correspondantes.

6. Dispositif d'avertissement de choc électrique selon l'une quelconque des revendications 3 à 5,
**caractérisé en ce que**
le microcontrôleur (24) est configuré pour calculer la direction du plus grand changement de tension à partir de la distribution de potentiel (19) au moyen d'une formation de gradients.

7. Dispositif d'avertissement de choc électrique selon l'une quelconque des revendications 3 à 6,
**caractérisé en ce que**
le microcontrôleur (24) est configuré pour générer des signaux de contrôle (18) pour le générateur de signal (26) afin de signaler quand un seuil de différence prédéfini du potentiel de mesure est dépassé.

8. Dispositif d'avertissement de choc électrique selon l'une quelconque des revendications 1 à 7,
**caractérisé en ce que**
la probe de référence (5) est reliée à un potentiel de terre (PE) défini comme équipotentiel (17) par l'intermédiaire d'une ligne de terre (39).

9. Dispositif d'avertissement de choc électrique selon l'une quelconque des revendications 1 à 7,
**caractérisé en ce que**
la probe de référence (5) a un accumulateur d'énergie (28) pour alimenter les probes de mesure (4) en énergie.

10. Dispositif d'avertissement de choc électrique selon l'une quelconque des revendications 1 à 9,
**caractérisé en ce**
**qu'**une ligne de connexion consistant en parties (30) de ligne de connexion a une ligne de communication (32), un conducteur de masse (36) et une ligne d'alimentation (34).

11. Dispositif d'avertissement de choc électrique selon la revendication 10,
**caractérisé en ce que**
la ligne de communication (32) est configurée pour transmettre des données des potentiels d'électrode numériques et des signaux de contrôle (18).

12. Dispositif d'avertissement de choc électrique selon l'une quelconque des revendications 1 à 11,
**caractérisé en ce que**
les corps flottable (7) sont globulaires et consistent en plastique transparent.

13. Dispositif d'avertissement de choc électrique selon l'une quelconque des revendications 1 à 12,
**caractérisé en ce que**
le générateur de signal (26) est un convertisseur de son et/ou un appareil d'éclairage ayant des représentations différentes de couleurs et plusieurs modes d'éclairage pour signaler des niveaux de danger différents.

14. Procédé pour la protection contre le choc électrique dans une zone engloutie (50) ayant des installations électriques (52), le procédé ayant des étapes suivantes :
la détection d'une distribution de potentiel électrique (19) dans la zone engloutie (50) au moyen d'un nombre n de probes de mesure (4) qui sont distribuées dans la zone engloutie (50) et qui ont chacune un potentiel de mesure (14) comme points de mesure pour le potentiel et consistent chacune en un corps flottable (7) ayant des électrodes de mesure (6) disposés sur sa face externe et ayant des potentiels d'électrode (16), d'une unité d'électronique (20) et d'un générateur de signal (26) et d'une alimentation en énergie (28),
**caractérisé en ce que**
les probes de mesure (4) sont reliées l'une à l'autre par l'intermédiaire de parties (30) de ligne de connexion afin de former une chaîne de probes (40) flottable et **en ce que** le potentiel de mesure (14) d'une probe de référence (5) est établi comme équipotentiel (17) relatif sans être relié à un potentiel de terre (PE).

15. Procédé selon la revendication 14,
**caractérisé en ce**
**qu'**aux probes de mesure (4) qui ne sont pas configurées comme probes de référence (5), les potentiels d'électrode (16) enregistré par les probes de mesure (6) correspondantes sont convertis en signaux numérique dans l'unité d'électronique (20) des probes de mesure (4) qui ne sont pas configurées comme probes de référence (5) au moyen d'un convertisseur analogique-numérique (22).

16. Procédé selon la revendication 14 ou la revendication 15, **caractérisé en ce que**
des étapes de traitement de signaux numériques sont exécutées centralement dans l'unité d'électronique (20) de la probe de référence (5) par l'intermédiaire d'un microcontrôleur (24).

17. Procédé selon la revendication 16,
**caractérisé en ce**
**qu'**aux probes de mesure (4) qui ne sont pas configurée comme probes de référence (5), des différences du potentiel de mesure se produisant par rapport à l'équipotentiel (17) sont identifiées par le microcontrôleur (24).

18. Procédé selon la revendication 16 ou la revendication 17, **caractérisé en ce que**
le potentiel de mesure (14) est calculé pour chaque probe de mesure (4) qui n'est pas configurée comme probe de référence (5) dans le microcontrôleur à partir des potentiels d'électrode (16) enregistrés aux électrodes de mesure (6) de la probe de mesure (4) correspondante.

19. Procédé selon l'une quelconque des revendications 16 à 18, **caractérisé en ce que**
la direction du plus grand changement de tension est calculée dans le microcontrôleur (24) à partir de la distribution de potentiel (19) au moyen de la formation de gradient.

20. Procédé selon l'une quelconque des revendications 16 à 19, **caractérisé en ce que**
des signaux de contrôle (18) sont générés par le microcontrôleur (24) pour le générateur de signal (24) afin de signaler quand un seuil de différence prédéfini du potentiel de mesure est dépassé.

21. Procédé selon l'une quelconque des revendications 14 à 20, **caractérisé en ce que**
la probe de référence (5) est reliée à un potentiel de terre (PE) défini comme équipotentiel (17) par l'intermédiaire d'une ligne de terre (39).

22. Procédé selon l'une quelconque des revendications 14 à 21, **caractérisé en ce que**
les probes de mesure sont alimentées en énergie par l'intermédiaire d'un accumulateur d'énergie (28) de la probe de référence (5).

23. Procédé selon l'une quelconque des revendications 14 à 22, **caractérisé en ce**
**qu'**une ligne de connexion consistant en parties (30) de ligne de connexion a une ligne de communication (32), un conducteur de masse (36) et une ligne d'alimentation (34), les potentiels d'électrode numériques et les signaux de contrôle (18) étant transmis par l'intermédiaire de la ligne de communication (32).

24. Procédé selon l'une quelconque des revendications 14 à 23, **caractérisé en ce que**
les corps flottables (7) sont globulaires et consistent en un plastique transparent, des niveaux de danger différents étant signalés au moyen du générateur de signal (26) configuré comme convertisseur de son et/ou comme appareil d'éclairage ayant des représentations différentes des couleurs et plusieurs modes d'éclairage.
